# EUROPEAN PATENT SPECIFICATION

(11) **EP 0 664 488 B1**
(45) Date of publication and mention of the grant of the patent: **11.03.1998**
(21) Application number: 94307900.4
(22) Date of filing: 27.10.1994
(51) Int. Cl.: G03F 7/033

(54) **Waterborne photoresists having binders neutralized with amino acrylates**
Wässrige Emulsionsphotoresiste mit durch Aminoacrylate neutralisiertem Bindemittel
Photoreserves en émulsion aqueuse contenant des liants neuralisés par des aminoacrylates

(30) Priority: 25.01.1994 US 186875; 18.02.1994 US 199037; 04.05.1994 US 238133
(43) Date of publication of application: 26.07.1995
(73) Proprietor: Morton International, Inc., Chicago, Illinois 60606-1596 (US)
(72) Inventor: Lundy, Daniel E., Panoma, California 91766 (US); Barr, Robert K., Laguna Niguel, California 92677 (US); Tran, Thanh N., Westminster, California 92683 (US)
(74) Representative: Bankes, Stephen Charles Digby

(56) References cited:
- DE-A- 3 639 955
- US-A- 5 045 435

## Description

The present invention is directed to photoresists, such as those used for forming printed circuit boards and more particularly to waterborne photoresists.

Photoimageable compositions useful as resists for forming printed circuits, printing plates, solder masks or the like have been used for some time now. The earliest photoresists were solvent-borne and solvent-developable. The development of aqueous-developable resists represented an advance in reducing solvent emissions in the immediate workplace and in the general environment. The continued emphasis in reducing organic solvent both from the workplace and from the general environment has spurred the search for waterborne photoresists which are formulated and applied as aqueous liquids.

U.S. patent No. 5,045,435 describes a waterborne photoresist composition which is developable in alkaline aqueous solution. The composition comprises a multifunctional monomer, a photoinitiator and a latex of water-insoluble carboxylated acrylic copolymer. To stabilize the composition and to adjust the viscosity, this patent teaches neutralizing the latex polymer to at least 25% with a base, such as ammonia, another amine, or sodium hydroxide.

In photoimageable compositions, such as described in U.S. Patent No. 5,045,435, where ammonia, primary, secondary or tertiary amines are used to neutralize the carboxylic acid functionality of the binder, it is attempted to remove the amines during the drying process. Any residual base creates tremendous water sensitivity. As a result, the drying window using these materials is narrow. In addition, the desired volatility of the amines create potential environmental concerns and compromise the fundamental reason for waterborne coatings in the first place, i.e., non-hazardous, emission-free coatings. Moreover, when "free amines" are used for the neutralizations, strong chelate bonds can also form with the copper surface, resulting in reactivity problems developing residues and, subsequently, etch retardation.

In accordance with the invention, there is provided a water-borne photoimageable composition in the form of an emulsion in an aqueous medium comprising
A) between 30 and 80 wt% of a latex binder polymer having an acid number of between 40 and 250,
B) between 15 and 50 wt% of alpha,beta-ethylenically unsaturated monomer(s), exclusive of amino acrylates,
C) between 0.1 and 25 wt% of a photoinitiator or photoinitiator chemical system which generates free radicals,
D) between 0.1 and 20 wt% of one or more amino acrylates, amino thioacrylates or amino acrylamides (hereinafter referred to as "neutralizing compounds D") having the general formula:

   A-X-B-CO-CR=CH₂ , where

   - A =: NZ₂ where the Z's are the same or different and are selected from H, linear or branched C₁-C₈ alkanes, C₆-C₁₂ cyclic or bicyclic alkanes, phenyl or C₁-C₄ alkyl- substituted phenyl, or naphthyl or C₁-C₄ mono or di alkyl-substituted naphthyl,
   or
   - A =: N-piperidino, N-morpholino, N-picolino, N-thiazino, N-ethyleneimino, or N-propyleneimino.
   - B =: O, S or NZ, (or nothing when X is (CₘH₂ₘ-O)ₙ).
   - X =: linear or branched C₁-C₁₈ alkanes, C₆-C₁₂ cyclic or bicyclic alkanes, phenyl or C₁-C₄ alkyl-substituted phenyl, naphthyl or C₁-C₄ mono or di alkyl-substituted naphthyl, or (CₘH₂ₘ-O)ₙ where m = 1-4 and n = 1-20.
   - R =: H or C₁-C₈ alkyl
   so as to neutralize between 1 and 40 mole percent of the acid functionality of the latex binder polymer; and
E) up to 40 wt% of an additional neutralizing base and/or polyether polyurethane associate thickener in amounts in conjunction with said neutralizing compounds (D) sufficient to stabilize the photoimageable composition as an aqueous emulsion,
the weight percentages being based on total weight of components A-E.

Latex binder polymers useful in the photoimageable composition of the present invention are typically prepared by emulsion polymerization of alpha, beta-unsaturated monomers. Sufficient acid functional monomers are used to provide the acid number of between 40 and 250, preferably at least 80. A typical emulsion polymerization procedure and some examples of suitable emulsions are found in U.S. Patent No. 3,929,743.

The remaining acid functionality of the binder polymer may be provided by monomers having the general formulae:
CH₂=CR¹-COOH, CH₂=R¹-COO-R²-OOC-R³-COOH, CH₂=CR¹-COO-R²-O-PO₃H₂, CH₂=CR¹-CONH-R²-O-PO₃H₂, and CH₂=CR¹-CO-NH-(R⁴)_{q}-COOH, wherein R¹ is H or Me, R² is C₁-C₆ alkylene, R³ is an C₁-C₆ alkylene or a phenylene group, the R⁴s are the same or different and are selected from CH₂ and CHOH, and q = 1 to 6.

Some specific examples of suitable acid functional monomers are acrylic acid, methacrylic acid, maleic acid, fumaric acid, citraconic acid, 2-methylpropane sulfonic acid, 2-propenoic acid, 2-methyl-2-sulfoethyl ester, 2-hydroxyethyl acryloyl phosphate, 2-hydroxypropyl acryloyl phosphate, 2-hydroxyalpha-acryloyl phosphate, etc. One or more of such acid functional monomers may be used to form the binder polymer. The acid functional monomers may be copolymerized with non-acid functional monomers, such as esters of acrylic acids, for example, methyl acrylate, methyl methacrylate, hydroxyethyl acrylate, butyl methacrylate, octyl acrylate, 2-ethoxy ethyl methacrylate, t-butyl acrylate, 1,5- pentanediol diacrylate, ethylene glycol diacrylate, 1,3- propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2,2-di(p-hydroxyphenyl)propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number.

To help ensure that the photoimageable composition is contact imageable, i.e., dries to a tack-free state, the glass transition temperature (T_{g}) of the latex binder polymer is preferably at least 60°C as measured by Differential Scanning Calorimetry (DSC) @ 20°C/min. The polymers have a weight average molecular weight (Mw) of between 500 and 200,000 as measured by gel permeation chromatography (GPS) using a polystyrene standard.

At least 1 mole percent of the acid functionality of the binder polymer is neutralized with one or more neutralizing compounds D. Total neutralization of the binder polymer is between 1 and 40 mole percent of the binder polymer acid functionality. Preferably, all of the acid functionality is neutralized by one or more neutralizing compounds D ; however, the neutralization may be accomplished with a combination of one or more neutralizing compounds D and another base, such as ammonia or a primary, secondary or tertiary amine.

Preferred amino acrylates are tertiary amino acrylates. Some suitable amino acrylates include, but are not limited to N,N-diethylaminoethyl acrylate, N,N-dimethylaminoethyl methacrylate, N,N-dimethylaminopropyl methacrylate, N,N-dimethylaminopropyl acrylate, and N,N-dimethylaminoethyl acrylate.

Unlike amines heretofore used to neutralize binder polymer, the amino acrylate, amino thioacrylate or amino acrylamide becomes a permanent part of the resist and is not removed during drying. Water sensitivity is avoided because the acrylate portion of the molecule polymerizes with other monomers B), rendering the amino acrylate molecules insoluble.

One surprising result of the use of neutralizing compounds D was elimination of developing residues and etch retardation. Either the chelate bond strength has been reduced with the amino acrylate(s) or the material in the unexposed resist is more soluble in the developing solution.

Another advantage achieved by use of neutralizing compounds D is faster exposure times. The exposure time is halved in several systems. The amino group appears to be an efficient proton source during the photocure. Faster exposure times mean more boards processed per hour. In addition, faster photospeed may allow for the removal of relatively expensive photoinitiators, thereby reducing overall cost.

Another benefit of the use of neutralizing compounds D is coatability. The neutralizing compound has the effect in the waterborne environment of reducing micelle size and consequently reducing viscosity. Reducing viscosity means that less water need be added; accordingly higher solids levels, i.e., up to 60 percent solids, have been achieved. As a general rule, materials have better coatability than materials with lower solids. Also drying times are reduced. In addition, materials with higher solids allow for thicker coatings which minimize pin holing and other coating defects related to thickness.

Another unexpected benefit of the use of neutralizing compounds D is reduction of the tackiness of the dried resist surface. Addition of acrylate monomers generally has the opposite effect. Because the phototool is in intimate contact with the photoresist surface during exposure, the surface must be tack-free or the phototool will be damaged.

Another unexpected advantage is rapid stripping time, stripping up to three times faster being achieved.

To produce the image, this negative-acting photoimageable composition contains photopolymerizeable monomers in addition to the neutralizing compound(s) D, particularly alpha,beta-ethylenically unsaturated monomers, including a substantial portion of multi-functional monomers. Useful monomers include those, listed above, used to form the binder polymers. Particularly suitable monomers include multifunctional acrylic monomers, such as tetraethylene glycol diacrylate (TEGDA), trimethylol propane triacrylate (TMPTA), butanediol dimethacrylate (BDDMA) and pentaerythritol triacrylate (PETA). The monomer fraction may include both water-soluble and water-insoluble monomers; however, the monomer fraction should contain a sufficiently high proportion of water-insoluble monomers(having solubilities in water at 20°C below about 0.3 g/100ml), e.g., above about 20 mole percent, so that the monomer fraction, as a whole, is insoluble in water.

To initiate polymerization of the monomers upon exposure to actinic radiation, the photoimageable composition contains an appropriate photoinitiator(s) or photoinitiator chemical system. Suitable photoinitiators include benzoin ethers, benzil ketals, acetophenones, benzophenones and related compounds with amines. Preferred initiators are thioxanthones, e.g., 2-isopropyl thioxanthones, particularly in conjunction with an amine.

Preferably, the waterborne photoimageable compositions include a poly(siloxane) selected from the group consisting of cyclo poly(dimethylsiloxanes), polyether modified poly(dimethylsiloxanes), poly(dimethylsiloxanes) and mixtures thereof, cyclo poly(dimethylsiloxanes) and polyether modified poly(dimethylsiloxanes) being preferred. The poly(siloxane)(s) are used at a level of between 0.1 and 10 wt% relative to components A)-D). Most preferably, the poly(siloxane) fraction is a mixture of cyclo poly(dimethylsiloxanes) and polyether modified poly(dimethylsiloxanes) at a weight ratio of between about 1:9 and about 9:1. An example of such a mixture is Dow Corning Q4- 3667 which is an 80:20 mixture of polyether modified poly(dimethylsiloxanes) and cyclo poly(dimethylsiloxanes). The poly(siloxanes) help to provide a tack-free surface, desirable for contact printing.

Useful poly(dimethylsiloxanes) have the general formula (CH₃)₃-[Si(Me)₂-O]ₙ-Si(CH₃)₃ where n is 0-4,000.

Cyclo poly(dimethylsiloxanes) have the general formula -[Si(Me₂)-O]ₙ- where n is 3 to 60.

Polyether Modified poly(dimethylsiloxanes) have the general formula: 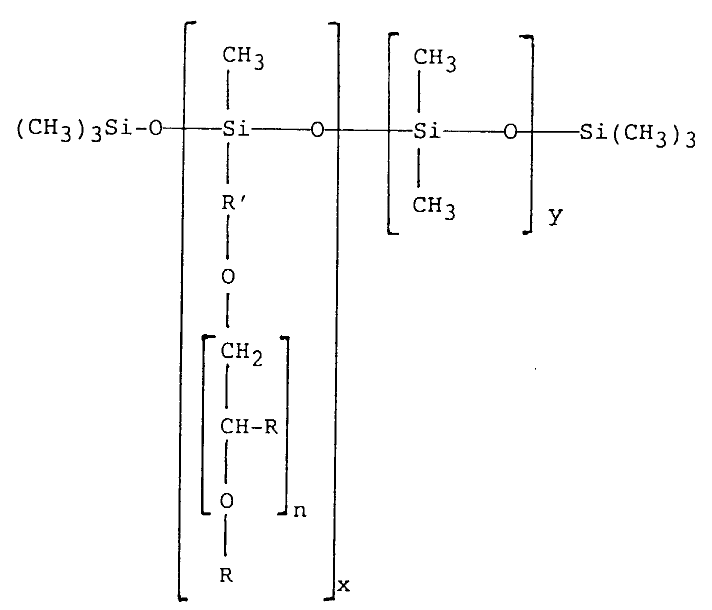 where
n = 0 to 1500, x = 1 to 2,000, y = 1 to 2000, R = H or CH₃
R' = (CH₂)₀₋₅ and the groups subscripted x and y are in random order.

Molecular weights of the poly(siloxanes) may vary over a very broad range. Low molecular poly(siloxanes) may have weight average molecular weights in the 100-600 Mw range; high molecular poly(siloxanes) may have weight average molecular weights in the 2,000 to 500,000 Mw range.

The waterborne photoimageable composition preferably includes a surfactant which is a fluoroaliphatic oxyethylene adduct at a level of between about 0.5 and about 3.0 wt% based upon the combined weights of components A)-D) above. Such surfactants have the general formula:
CF₃-(CF₂)ₙ-Y-Xₘ-Z; where n = 0 to 20, Y = SO₂-N(C₁-C₁₀alkyl), X = CH₂-CH₂-O or CH(CH₃)CH₂-O, m = 0 to 20, and Z = CH₂-CH₂-OH or CH(CH₃)-CH₂-OH.

Stabilization of the emulsion is provided, at least, in part, by the neutralization of the acid functional moieties of the binder polymer. As is taught in U.S. Patent Application No. 08/199,037, stabilization of the emulsion and viscosity adjustment may be assisted using a polyether polyurethane associate thickener. Polyether polyurethane thickeners are polymers having at least two hydrophobic segments which are the residues of hydrophobic isocyanates, generally isocyanates having isocyanate functionality of 2 or higher, and at least one hydrophilic polyether segment joining the hydrophobic segments by urethane linkages. The block polymers which act as associate thickener may take a variety of forms including ABA, (AB)ₙ, star polymers and the like. The polyether segments are formed from poly(alkylene oxide) segments, formed from monomers such as propylene oxide and ethylene oxide. To be sufficiently hydrophilic, generally it is necessary that at least about 3 mole percent of the poly(alkylene oxide) segment(s) be ethylene oxide residues. The hydrophobic portion of the isocyanate residue is typically an alkyl, cycloalkyl or aromatic moiety. Polyether polyurethane associate thickeners and their function are described, for example by A.J.M. Knoef, and H. Slingerland, "Urethane-Based Polymeric Thickeners for Aqueous Coating Systems" JOCCA, Sept. 1992, pp 335-338; J.H. Bieleman et al. Polymers Paint Colour Journal 1986, V.176(4169) pp. 450-460; and A.J. Whitton and R.E. Van Doren Polymers Paint Colour Journal 1991, V.181(4286) pp. 374-377. Particularly suitable polyether polyurethane associate thickeners and their synthesis are described in U.S. Patent No. 4,079,028 to Emmons et al. Suitable polyether polyurethane associate thickeners are also described in U.S. Patents Nos. 4,426,485 to Hoy et al. and 4,743,698 to Ruffner et al. Examples of suitable commercially available associate thickeners are DSX1514 (Henkel) and QR708 (Rohm and Haas). When used, associate thickeners are used at levels of between about 1 and about 40 relative to the total weight of components A)-E) (the associate thickener comprising all or part of component E).

By using the polyether polyurethane associate thickener, less neutralization of the binder polymer latex is generally required.

In addition to the components listed above, minor amounts (generally less than about 10 wt% total based on the weight of A-E) of conventional additives may be used, including; antifoam agents, antioxidants, dyes, adhesion promoters, slip aids, and other surface tension modifiers.

In a preferred method of preparing the waterborne photoimageable composition of the present invention, those components, such as initiators, antioxidants and dyes, most compatible with a hydrophobic phase are admixed with the monomer fraction to produce a monomer base and those components most compatible with an aqueous phase with the latex polymer, such as antifoam, neutralizer surfactant and associate thickener, are admixed to form a polymer mix. The hydrophobic phase and polymer mix are blended to form an hydrophobic phase-in-water emulsion. Subsequently, high boiling solvents, surfactants, including slip aids, surface tension modifiers, and adhesion promoters are added.

The final waterborne composition is generally between 20 and 40 wt. percent solids. In the waterborne composition, the binder polymer (exclusive of amino acrylate(s)) comprises between 10 and 30 wt% solids, neutralizing compounds D from 0.05 to 10 wt% solids, additional monomers from 3 to 20 wt% solids, initiator from 0.3 to 10 wt% solids. Poly(siloxane(s)), when used, are typically used at between .02 and 1 wt% of the emulsified waterborne composition. If used, a fluoroaliphatic oxyethylene adduct surfactant will typically be present at between .06 and 2 wt% of the emulsified waterborne composition. Associate thickeners typically comprise between 0.5 and 20 wt% of the emulsified waterborne photoimageable composition.

The composition may be coated by any of the coating systems known in the art for coating solvent-borne photoimageable compositions, such as roll coating, dip coating, spray coating or curtain coating.

The compositions of the present invention are applied in a conventional manner, either as liquid compositions directly to a metal clad blank laminate or to a polymeric support sheet to form a dry film. After coating, the composition is dried to remove water and also to remove volatiles, such as ammonia or amine, water, etc., thereby rendering the solution polymer insoluble in acidic or neutral aqueous medium. As the photoimageable composition dries, the system coalesces into a continuous film. Drying is preferably carried out at somewhat elevated temperatures, both to hasten removal of the water, and to drive off the ammonia or volatile amine. Preferably, drying is carried out at a temperature of about 90°C.

In forming a dry film, a water-borne composition is applied to flexible support sheet, e.g., polyethylene terephthalate, and then dried to remove water and volatiles. Subsequently, a protective sheet, e.g., polyethylene, is applied to the photoimageable composition layer, and the dry film is rolled into reels. In drying the photoimageable composition layer, it is found desirable in some cases to leave a residual water content of between 1 and 2 wt. % (relative to solids of the photoimageable composition layer). This residual water acts to allow the photoimageable composition layer to conform to surface defects of a substrate, e.g., a copper-clad board, when laminated thereto.

Processing is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1% sodium carbonate solution. The alkali solution causes salt formation with the carboxylic groups of the binder polymers, rendering them soluble and removable. After development, an etchant may be used to remove copper from those areas where the resist was removed, thereby forming a printed circuit. The remaining resist is then removed using an appropriate stripper.

Not only can waterborne primary imaging photoresists be provided in accordance with the invention, but solder mask- forming compositions can be provided as well. By solder mask is meant herein a hard, permanent layer which meets at least the minimal requirements of the abrasion resistance tests as defined in IPC-SM-84OB, Table 12, Summary of Criteria for Qualification/Conformance (Institute for Interconnecting Circuits). To become hard and permanent, it is generally necessary that the photoimageable composition be curable after exposure, development and processing of the board, e.g., by thermal and/or UV curing. One way to provide a post-cure is to provide binder polymer having free -OH groups in the backbone that may be cured, for example, by cross-linking with aminoplast resins, such as melamine/formaldehyde resins and urea/formaldehyde resins. Alternatively, the photoimageable composition may contain a compatible epoxy resin and a curative for the epoxy resin. It is found that water-borne photoimageable compositions in accordance with the invention exhibit excellent shelf lives after application to copper substrates and can remain on a copper-clad board upwards of several days.

The invention will now be described in greater detail by way of specific examples.

### Example 1

Waterborne photoimageable compositions were formulated according to Table 1 below. Performance data is according to Table 2 below. "Monomer base" in Table 1 is per Table 3; all materials being mixed together, filtered and subsequently added to the aqueous portion. Table 4 is processing conditions for preparing a printed circuit board. Formulations 1 and 4 are in accordance with the invention; formulations 2 and 3 are comparative.

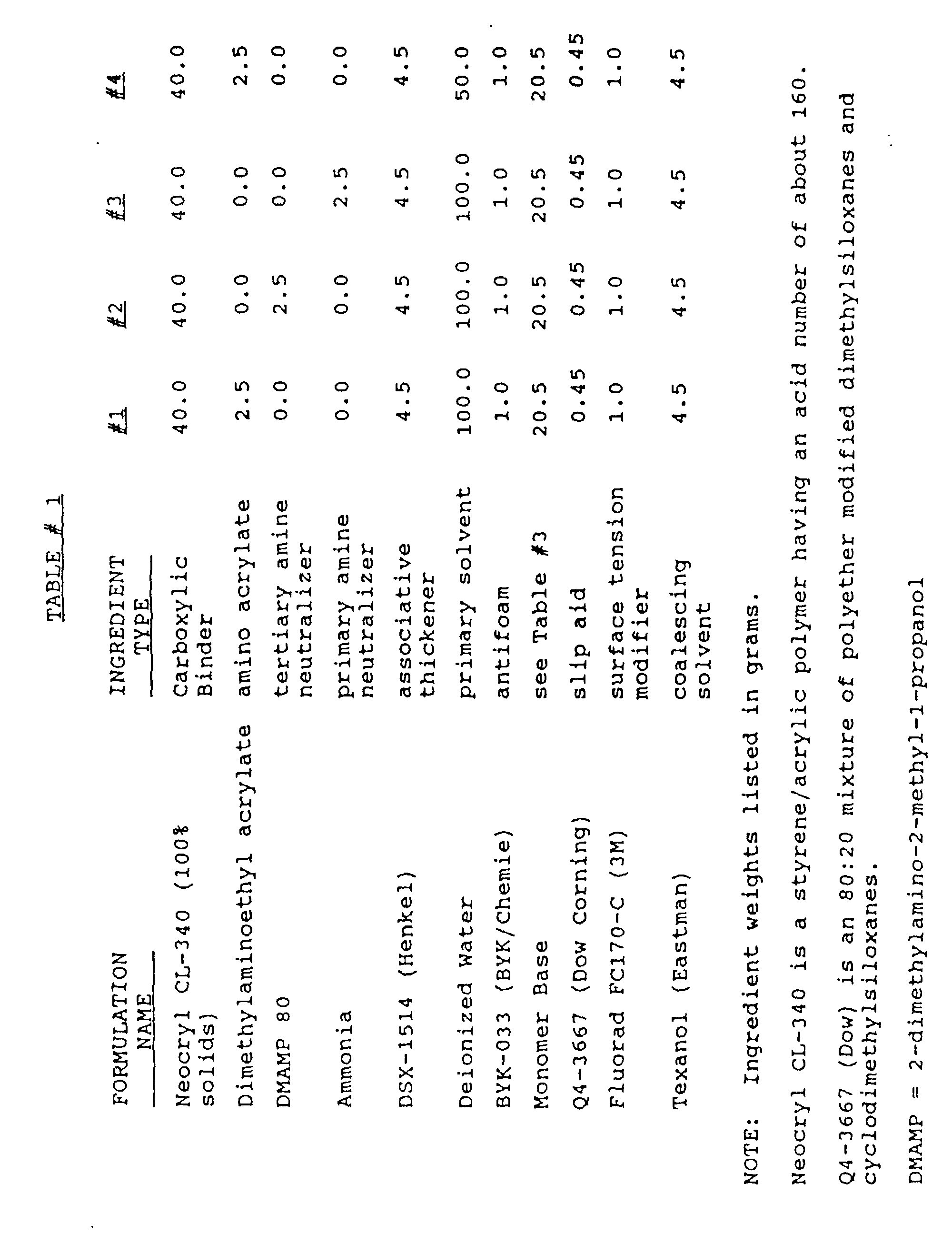

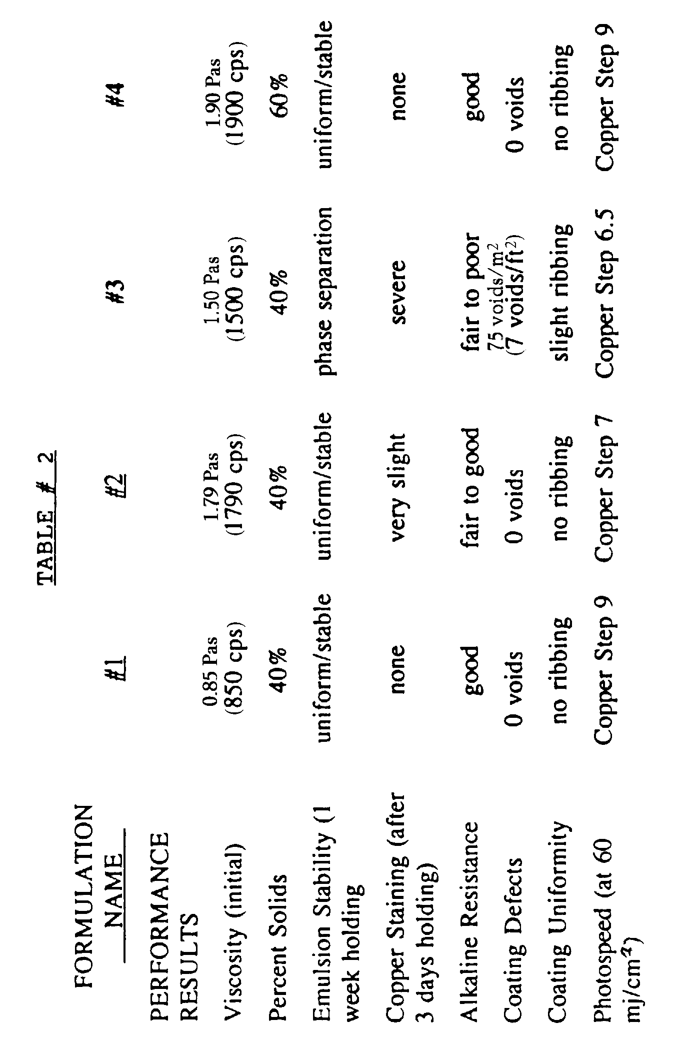

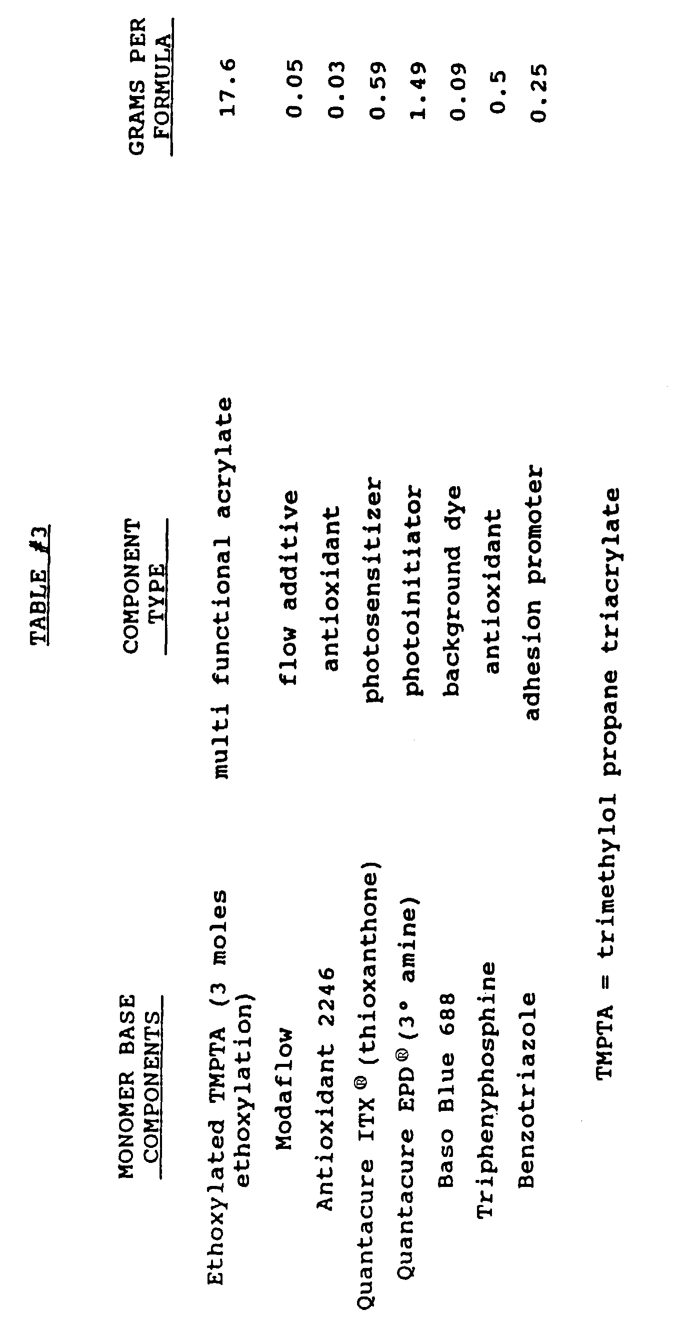

### PROCESSING CONDITIONS

Coating - Burkle (single sided) Roller Coater, 8.7 threads per cm (22 per inch)
Substrate - Copper Clad
Exposure - HMW ORC, model 301 B, diazo art work
Development - 1% sodium carbonate monohydrate, 29.5°C (85° F), 2x breakpoint
Etching - 3 normal cupric chloride, 60°C (140° F), 1.3 x minimum etch
Stripping - 3% sodium hydroxide, 54.5°C (130° F)

### PERFORMANCE EXPLANATION

Viscosity - measured on a Brookfield viscometer initially and after one week at 21°C (70° F)
Emulsion Stability - Stability was rated based on the overall uniformity of the lacquer mixture
Alkaline Resistance - the resistance was measured after alkaline etch at pH 9.2
Coating Defects - the number of coating voids (thin spots) were counted after roller coating
Coating Uniformity - the uniformity was observed immediately after coating
Photospeed - using a Stouffer 21 step to measure the last remaining step (each step varies by 1/2)
   (Note: a higher step would indicate a higher degree of polymerization)
Staining - observation of the level staining on the copper surface after development

## Claims

1. A water-borne photoimageable composition in the form of an emulsion in an aqueous medium comprising
A) between 30 and 80 wt% of a latex binder polymer having an acid number of between 40 and 250,
B) between 15 and 50 wt% of alpha,beta-ethylenically unsaturated monomer(s), exclusive of amino acrylates,
C) between 0.1 and 25 wt% of a photoinitiator or photoinitiator chemical system which generates free radicals,
D) between 0.1 and 20 wt% of one or more amino acrylates, amino thioacrylates or amino acrylamides (referred to as "neutralizing compounds D") having the general formula:
A-X-B-CO-CR=CH₂ ,
where
A = NZ₂ where the Z's are the same or different and are selected from H, linear or branched C₁-C₈ alkanes, C₆-C₁₂ cyclic or bicyclic alkanes, phenyl or C₁-C₄ alkyl- substituted phenyl, or naphthyl or C₁-C₄ mono or di alkyl-substituted naphthyl,
or
A = N-piperidino, N-morpholino, N-picolino, N-thiazino, N-ethyleneimino, or N-propyleneimino.
B = O, S or NZ, (or nothing when X is (CₘH₂ₘ-O)ₙ).
X = linear or branched C₁-C₁₈ alkanes, C₆-C₁₂ cyclic or bicyclic alkanes, phenyl or C₁-C₄ alkyl-substituted phenyl, naphthyl or C₁-C₄ mono or di alkyl-substituted naphthyl, or (CₘH₂ₘ-O)ₙ where m = 1-4 and n = 1-20.
R = H or C₁-C₈ alkyl
so as to neutralize between 1 and 40 mole percent of the acid functionality of the latex binder polymer; and
E) up to 40 wt% of an additional neutralizing base and/or polyether polyurethane associate thickener in amounts in conjunction with said neutralizing compounds (D) sufficient to stabilize the photoimageable composition as an aqueous emulsion,
the weight percentages being based on total weight of components A-E.

2. A photoimageable composition according to claim 1 wherein (E) comprises a polyether polyurethane associate thickener at between 1 and 40 wt% based on total weight of components A-E.

3. A dry film comprising a support sheet having thereon a photoimageable layer formed by applying to the support sheet a layer of a photoimageable composition according to any preceding claim and drying the layer.

## Patentansprüche

1. Wäßrige Lichtabbildungszusammensetzung, in der Form einer Emulsion in einem wäßrigen Medium mit
A) zwischen 30 und 80 Gew.-% eines Latexbindemittelpolymers mit einer Säurezahl zwischen 40 und 250,
B) zwischen 15 und 50 Gew.-% alpha,beta-ethylenisch ungesättigtem Monomer oder ungesättigten Monomeren ausgenommen Aminoacrylate,
C) zwischen 0,1 und 25 Gew.-% eines Photoinitiators oder Photoinitiatorchemikaliensystems, welche freie Radikale erzeugen,
D) zwischen 0,1 und 20 Gew.-% eines oder mehrerer Aminoacrylate, Aminothioacrylate oder Aminoacrylamide (als "neutralisierende Verbindungen D" bezeichnet) der allgemeinen Formel
A-X-B-CO-CR=CH₂,
worin
A = NZ₂, worin die Gruppen Z gleich oder verschieden sind und unter H, linearen oder verzweigten C₁-C₈-Alkanen, zyklischen oder bizyklischen C₆-C₁₂-Alkanen, Phenyl oder C₁-C₄-alkylsubstituiertem Phenyl oder Naphthyl oder C₁-C₄-monooder dialkylsubstituiertem Naphthyl ausgewählt sind oder
A = N-Piperidino, N-Morpholino, N-Picolino, N-Thiazino, N-Ethylenimino oder N-Propylenimino,
B = O, S oder NZ (oder nichts, wenn X (CₘH₂ₘ-O)ₙ ist),
X = lineare oder verzweigte C₁-C₁₈-Alkane, zyklische oder bizyklische C₆-C₁₂-Alkane, Phenyl oder C₁-C₄-alkylsubstituiertes Phenyl, Naphthyl oder C₁-C₄-mono- oder -dialkylsubstituiertes Naphthyl oder (CₘH₂ₘ-O)ₙ, worin m = 1-4 und n = 1-20,
R = H oder C₁-C₈-Alkyl,
um so zwischen 1 und 40 Mol-% der Säurefunktionalität des Latexbindemittelpolymers zu neutralisieren, und
E) bis zu 40 Gew.-% einer zusätzlichen neutralisierenden Base und/oder eines Polyetherpolyurethan-Kombinationsverdickungsmittels in ausreichenden Mengen in Verbindung mit den neutralisierenden Verbindungen (D), um die Lichtabbildungszusammensetzung als eine wäßrige Emulsion zu stabilisieren, wobei die Gewichtsprozentsätze sich auf das Gesamtgewicht der Komponenten A bis E beziehen.

2. Lichtabbildungszusammensetzung nach Anspruch 1, worin (E) ein Polyetherpolyurethan-Kombinationsverdickungsmittel in einer Menge zwischen 1 und 40 Gew.-%, bezogen auf das Gesamtgewicht der Komponenten A bis E, umfaßt.

3. Trockenfilm mit einem Trägerbogen mit einer Lichtabbildungsschicht darauf, die durch Aufbringung einer Schicht einer Lichtabbildungszusammensetzung nach einem der vorausgehenden Ansprüche auf dem Trägerbogen und Trocknung der Schicht gebildet wurde.

## Revendications

1. Composition, à base d'eau, capable de former une image photographique, sous la forme d'une émulsion dans un milieu aqueux comprenant
A) entre 30 et 80 % en masse d'un polymère liant à base de latex ayant un indice d'acide situé entre 40 et 250,
B) entre 15 et 50 % en masse d'un ou de monomères à insaturation alpha, bêta - éthylénique, les amino-acrylates étant exclus,
C) entre 0,1 et 25 % en masse d'un photoinitiateur ou d'un système chimique photoinitiateur qui génère des radicaux libres,
D) entre 0,1 et 20 % en masse d'un ou plusieurs amino-acrylates, amino-thioacrylates ou amino-acrylamides (dits « composés neutralisants D ») ayant pour formule générale :
A-X-B-CO-CR=CH₂,
dans laquelle
A = NZ₂, où les Z sont identiques ou différents et sont choisis parmi H, les restes alcanes linéaires ou ramifiés contenant 1 à 8 atomes de carbone, les restes alcanes cycliques ou bicycliques contenant 6 à 12 atomes de carbone, le reste phényle ou les restes phényles substitués par un reste alkyle contenant 1 à 4 atomes de carbone, ou le reste naphtyle ou les restes naphtyles substitués par un ou deux restes alkyles contenant 1 à 4 atomes de carbone,
ou
A = N-pipéridino, N-morpholino, N-picolino, N-thiazino, N-éthylèneimino ou N-propylèneimino.
B = O, S ou NZ (ou rien si X est (CₘH₂ₘ-O)ₙ).
X = un reste alcane linéaire ou ramifié contenant 1 à 18 atomes de carbone, un reste alcane cyclique ou bicyclique contenant 6 à 12 atomes de carbone, un reste phényle ou phényle substitué par un reste alkyle contenant 1 à 4 atomes de carbone, un reste naphtyle ou naphtyle mono- ou disubstitué par un reste alkyle contenant 1 à 4 atomes de carbone ou un reste (CₘH₂ₘ-O)ₙ où m = 1-4 et n = 1-20.
R = H ou un reste alkyle contenant 1 à 8 atomes de carbone
de façon à neutraliser entre 1 et 40 moles % des fonctions acides du polymère liant à base de latex et
E) jusqu'à 40 % en masse d'une autre base neutralisante et/ou d'un épaississant associé polyuréthanne polyéther, en des quantités, en relation avec celles desdits composés neutralisants (D), suffisantes pour stabiliser la composition capable de former une image photographique sous la forme d'une émulsion aqueuse,
les pourcentages en masse étant basés sur la masse totale des composants A - E.

2. Composition capable de former une image photographique selon la revendication 1, dans laquelle (E) comprend un épaississant associé polyuréthanne polyéther en une quantité située entre 1 et 40 % en masse par rapport à la masse totale des composants A - E.

3. Film sec comprenant une feuille support sur laquelle se trouve une couche capable de former une image photographique, formé par l'application, sur la feuille support, d'une couche d'une composition capable de former une image photographique selon une quelconque des revendications qui précèdent, et par le séchage de la couche.
